# EUROPEAN PATENT APPLICATION

(11) **EP 4 530 595 A1**
(43) Date of publication of application: **02.04.2025**
(21) Application number: 23200982.9
(22) Date of filing: 29.09.2023
(51) Int. Cl.: G01M 5/00, G01M 7/00, G01R 31/62

(54) **A METHOD, A MONITORING SYSTEM AND A TRANSFORMER ARRANGEMENT**

(71) Applicant: Hitachi Energy Ltd, 8050 Zürich (CH)
(72) Inventor: DANERYD, Anders, 723 49 Västerås (SE); SAHU, Kiran Chandra, 723 44 Västerås (SE)
(74) Representative: Epping - Hermann - Fischer

(57) **Abstract**

A method 2 for monitoring of structural degradation in a transformer arrangement 3 The transformer arrangement 3 comprises a transformer tank 10 and a transformer 12 enclosed by the transformer tank 10 and immersed in an insulating fluid inside the transformer tank 10. The method 2 is performed by a monitoring system 400 comprising a control unit 1, an actuator assembly 14 controllable to dynamically excite the transformer arrangement 3, and a sensor assembly 16 configured to detect a vibrational response V in the transformer tank 10 of the transformer arrangement 3. The method 2 comprises, by the control unit 1: controlling S1 the actuator assembly 14 to dynamically excite the transformer arrangement 3; detecting S2, via the sensor assembly 16, a vibrational response V of the transformer arrangement 3; comparing S3 the vibrational response V to a reference response R; and determining S4 a structural degradation of the transformer arrangement 3 in response to the comparison between the vibrational response V and the reference response R exceeding a threshold value. A monitoring system 400 and a transformer arrangement are also disclosed.

## Description

### TECHNICAL FIELD

The present disclosure relates to a computer-implemented method, a monitoring system and a transformer arrangement for monitoring structural degradation of a transformer and related wetted parts comprised in the transformer arrangement. In particular, the disclosure relates to mechanically exciting a transformer tank at at least one frequency and analysing a vibrational response.

### BACKGROUND

A number of solutions have been proposed for monitoring transformer degradation in the form of winding clamping pressure relaxation, and other incipient mechanical transformer faults, related to in-oil components in transformer tanks, for the purpose of providing early warning of incipient faults. However, present solutions are not robust or reliable enough for on-line monitoring and diagnostics. Some examples include:
- Excitation of winding with electrical pulse (direct excitation)
- Excitation of the tank with e.g., a hammer impact
- Frequency of winding vibrations related to clamping pressure, during normal operation.

### SUMMARY

Therefore, an object of the disclosure is to provide an improved method, an improved monitoring system and an improved transformer arrangement for mechanically exciting a transformer tank over at at least one frequency using at least one actuator and simultaneously measuring a resulting tank vibration response using at least one sensor.

According to a first aspect of the present disclosure, the object is at least partly achieved by a computer-implemented method according to claim 1.

Hence there is provided a computer-implemented method for monitoring of structural degradation in a transformer arrangement comprising a transformer tank and a transformer enclosed by the transformer tank and immersed in an electrically insulating fluid inside the transformer tank. The method is performed by a monitoring system comprising a control unit, an actuator assembly controllable to dynamically excite the transformer arrangement, and a sensor assembly configured to detect a vibrational response in the transformer arrangement. The method comprises, by the control unit: controlling the actuator assembly to dynamically excite the transformer arrangement; detecting, via the sensor assembly, a vibrational response of the transformer arrangement; comparing the vibrational response to a reference response; and determining a structural degradation of the transformer arrangement in response to the comparison between the vibrational response and the reference response exceeding a threshold value.

The transformer may be a single-phase transformer or a multi-phase transformer. The transformer may comprise at least a primary and a secondary winding clamped by press plates between a top yoke and a bottom yoke of a transformer core. During operation of the transformer, the clamping pressure of the press plates may relax, which may lead to short-circuit incidents. Other structural changes may also occur. The relaxation of the clamping pressure and other structural changes may be detected by the method and monitoring system set out in the present disclosure.

The actuator assembly may comprise at least one actuator, such as an electrodynamic shaker, arranged on, or inside, the transformer tank. The control unit controls the actuator assembly to dynamically excite the transformer arrangement at at least one frequency. The term "dynamically excite" is understood to mean exciting vibrations using a variable force, such as applying a sinusoidally varying force of an electrodynamic shaker. This is opposed to applying a constant force or an impulse. By mechanically energizing the transformer arrangement with electrodynamic shakers and monitoring the resulting vibrational response using standard vibration sensors it is possible to identify incipient potentially detrimental changes in the mechanical characteristics of the transformer active part, and in other mechanical sub-structures immersed in the insulating fluid.

Further, the excitation of the "transformer arrangement" is herein to be understood as exciting vibrations in the transformer tank and/or in the transformer with its sub-structures, such as windings, press plates, core, etc.

Accordingly, the sensor assembly may comprise at least one sensor and may similarly be arranged on, or inside, the transformer tank and configured to detect a vibrational response resulting from the excited vibrations. Evolution of the frequency content of the vibrational response, as compared to the reference response, will reveal changes to mechanical properties of sub-structures of the transformer arrangement. The sensor assembly may alternatively be arranged inside the transformer tank.

The threshold value may be set depending on individual transformer and transformer tank configurations. If structural degradation is determined, the control unit may indicate to users or operators of the transformer arrangement what sub-structures have degraded or that the status of the transformer arrangement needs to be investigated further. Alternatively, the control unit may shut down the transformer.

The control unit may be configured to perform the method continuously or intermittently at pre-determined intervals.

Optionally, the actuator assembly is controlled to dynamically excite the transformer arrangement over a range of frequencies. Thereby, the method may be a swept frequency response analysis (SFRA) method, where the actuator assembly excites the transformer arrangement over a wide range of frequencies.

Alternatively, the actuator assembly may be controlled to excite the transformer arrangement around frequencies of interest, such as at frequencies of symmetric and asymmetric resonant vibrational modes of the transformer and of the transformer windings. Particularly energetic axial resonance vibrations of the transformer windings (along an extension of the transformer windings) are known to occur at approximately the double operational frequency of the grid, i.e. at double 50 Hz or 60 Hz, such as at 100 Hz and 120 Hz. Structural changes may be expected to appear at these frequencies, but not only at these frequencies, due to fatigue of the sub-structures of the transformer and/or transformer arrangement. Further, the method and monitoring system of the disclosure allows the study of radial resonance vibrations which are also excited during normal operation of the transformer.

Optionally, the range of frequencies is between 5 Hz and 5000 Hz.

The vibrational response resulting from structural degradation may be unpredictable. A wide frequency range of the excited vibrations improves the chances of detecting structural changes in the vibrational response.

Optionally, upon determining the structural degradation of the transformer arrangement at a certain frequency of excitation, the method further comprises exciting vibrations at frequencies of higher resolution around said frequency.

Exciting vibrations at frequencies of higher resolution is understood to mean exciting vibrations in smaller incremental steps around a frequency of interest in order to better characterise deviations of the vibrational response from the reference response.

According to a second aspect of the present disclosure, the object is at least partly achieved by a monitoring system according to claim 5.

Hence, there is provided a monitoring system for monitoring of structural degradation in a transformer arrangement. The monitoring system comprises a control unit and an actuator assembly controllable by the control unit to dynamically excite a transformer tank, and a sensor assembly configured to detect a vibrational response in the transformer tank. The control unit is configured to control the actuator assembly to dynamically excite the transformer arrangement, to detect, by the sensor assembly, a vibrational response of the transformer arrangement, to compare the vibrational response to a reference response, and to determine a structural degradation of the transformer arrangement in response to the comparison between the vibrational response and the reference response exceeding a threshold value.

As stated hereinabove, the actuator assembly of the monitoring system may comprise at least one actuator, such as an electrodynamic shaker. The sensor assembly may comprise at least one vibration sensor, such as a fibre optic accelerometer. The control unit may have processing capacity and may be configured to communicate wirelessly, or by cable, with the actuator assembly and the sensor assembly to perform the actions of the method. The monitoring system may further comprise visual or audible indicators, such as graphic displays, speakers, etc., to display status and/or to alert operators and users of the transformer arrangement about structural degradation of the transformer arrangement. The control unit may further control switches to shut down the transformer in case of detected urgent structural changes.

According to a third aspect of the present disclosure, the object is at least partly achieved by a transformer arrangement according to claim 6.

Hence, there is provided a transformer arrangement comprising a transformer tank, a transformer enclosed by the transformer tank and immersed in an electrically insulating fluid inside the transformer tank, and a monitoring system according to any one of the embodiments of the second aspect of the disclosure. The control unit of the monitoring system is configured to perform the method of any one of the embodiments of the first aspect of the disclosure.

The transformer arrangement may thus comprise a conventional transformer tank and transformer, which are further arranged with a monitoring system according to the second aspect of the disclosure.

Optionally, the transformer tank is formed by, and comprises walls, a base and a lid, which walls extend between the base and the lid and which walls comprise reinforcing beams and plate fields between the beams.

The lid of the transformer tank is made of relatively thick material, e.g. steel of >30 mm. The lid may comprise openings for service and inspection and bushings enabling electric connection with the transformer inside the tank. The lid is relatively close to the top press plates of the windings of the transformer.

The base of the transformer tank is also made of a relatively thick material, e.g steel of >30-40 mm. The transformer is arranged standing on the base inside the transformer tank. Therefore, there is a strong mechanical connection between the base and the transformer.

The reinforcing beams strengthen the walls and also suppress vibrations of the walls, which vibrations emanate from vibrations of the windings during operation of the transformer. The vibrations are transferred to the walls via the insulating fluid which surrounds the transformer inside the tank. The plate fields are to be understood as parts of the walls between the beams.

Optionally, the actuator assembly is mounted on at least one beam of the walls of the transformer tank. The beams may provide strong energization and mechanical coupling of the transformer tank when exciting the vibrations by the actuator assembly.

Optionally, the actuator assembly is mounted on the lid of the transformer tank. The relatively thick material of the lid provides a strong energization and mechanical coupling of the transformer tank when exciting the vibrations by the actuator assembly.

Optionally, the actuator assembly is mounted on the base of the transformer tank. The relatively thick material of the base provides a strong energization and mechanical coupling of the transformer tank when exciting the vibrations by the actuator assembly. Further, the direct mechanical connection between the base and the transformer results in less reliance on transmission of vibrations through the insulating fluid.

Optionally, the sensor assembly is mounted on at least one plate field of the transformer tank walls and arranged distanced from adjacent beams. Mounting the sensor assembly on a field plate may provide local readings of the vibrational response.

Optionally, the sensor assembly is mounted on the lid of the transformer tank. The lid is arranged relatively close to the top end of the windings as compared to other parts of the transformer tank. Therefore, mounting the sensor assembly may provide more accurate readings of structural degradation of the transformer.

Optionally, the sensor assembly is mounted on the base of the transformer tank. The direct mechanical connection between the base and the transformer results in less reliance on transmission of vibrations through the insulating fluid. Thereby, readings of sensors mounted on the base may be more accurate.

Optionally, the sensor assembly is mounted on an inside of the transformer tank. The sensor assembly may be mounted directly on the transformer, such as on the windings or on the press plates of the transformer. The sensors may be configured to wirelessly communicate with the control unit outside the transformer tank, such as by electromagnetic coupling between LC circuits. The sensors may further be arranged and configured to extend along electric field lines of the transformer in operation in order to reduce interfering electric potentials across the sensors.

According to a fourth aspect of the present disclosure, the object is at least partly achieved by a computer program product according to claim 15.

Hence, there is provided a computer program product comprising program code for, when executed by the control unit, performing the method of any one of the embodiments of the first aspect of the disclosure.

According to a fifth aspect of the present disclosure, the object is at least partly achieved by a non-transitory computer-readable storage medium according to claim 16.

Hence, there is provided a non-transitory computer-readable storage medium comprising instructions, which when executed by the control unit of the second aspect of the disclosure, causes the control unit to perform the method of any one of the embodiments of the first aspect of the disclosure.

The control unit may be connected to the non-transitory computer-readable storage medium having thereon the computer program product, which comprises code to cause the control unit to execute the method of the disclosure. The control unit may use the software/computer program product to control excitation of vibrations of the transformer tank. The computer program is configured for the control unit to run the method in the most efficient possible manner. The computer program and the control unit may perform data acquisition and signal processing and run algorithms for assessing whether a change in a recorded vibration spectrum is due to an incipient degradation or not. Assessment of the structural degradation may involve machine learning.

The above aspects, accompanying claims, and/or examples disclosed herein above and later below may be suitably combined with each other as would be apparent to anyone of ordinary skill in the art.

Additional features and advantages are disclosed in the following description, claims, and drawings, and in part will be readily apparent therefrom to those skilled in the art or recognized by practicing the disclosure as described herein.

### BRIEF DESCRIPTION OF THE DRAWINGS

Further objects and advantages of, and features of the disclosure will be apparent from the following description of one or more embodiments, with reference to the appended drawings, where:
- Fig. 1: shows a flowchart of the method according to the first aspect of the disclosure.
- Fig. 2: shows an exemplary diagram of a vibrational response compared to a reference response of the transformer arrangement according to the third aspect of the disclosure.
- Fig.3: shows a schematic example of the monitoring system according to the second aspect of the disclosure.
- Fig. 4: shows an example of the transformer arrangement according to the third aspect of the disclosure.
- Fig. 5: shows a perspective view of an exemplary transformer arrangement according to the third aspect of the disclosure.
- Fig. 6: shows a schematic diagram of a computer system for implementing examples herein.

### DETAILED DESCRIPTION OF EXAMPLE EMBODIMENTS OF THE INVENTION

The present disclosure is developed in more detail below referring to the appended drawings which show examples of embodiments. The disclosure should not be viewed as limited to the described examples of embodiments. Like numbers refer to like elements throughout the description.

The terminology used herein is for the purpose of describing particular aspects of the disclosure only and is not intended to limit the invention. As used herein, the singular forms "a", "an" and "the" are intended to include the plural forms as well, unless the context clearly indicates otherwise. Unless otherwise defined, all terms (including technical and scientific terms) used herein have the same meaning as commonly understood by one of ordinary skill in the art to which this disclosure belongs.

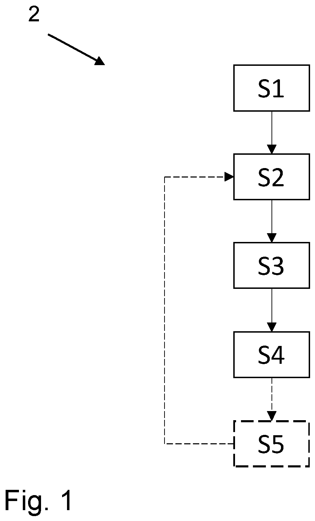

**Fig. 1** illustrates a flowchart of the method 2 for monitoring of structural degradation in a transformer arrangement 3 according to the first aspect of the disclosure. The transformer arrangement 3 comprises a transformer tank 10 and a transformer 12 enclosed by the transformer tank 10 and immersed in an electrically insulating fluid inside the transformer tank 10. The method 2 is performed by a monitoring system 400 comprising a control unit 1, an actuator assembly 14 controllable to dynamically excite the transformer arrangement 3, and a sensor assembly 16 configured to detect a vibrational response V in the transformer tank 10 of the transformer arrangement 3. The method 2 comprises, by the control unit 1: controlling S1 the actuator assembly 14 to dynamically excite the transformer arrangement 3; detecting S2, via the sensor assembly 16, a vibrational response V of the transformer arrangement 3; comparing S3 the vibrational response V to a reference response R; and determining S4 a structural degradation of the transformer arrangement 3 in response to the comparison between the vibrational response V and the reference response R exceeding a threshold value.

The reference response R is an initially measured nominal vibrational response recorded at a range of excitation frequencies for a particular transformer arrangement 3 when it is installed for service, or after undergoing maintenance or repairs.

The actuator assembly 14 may comprise at least one actuator, such as an electrodynamic shaker, arranged on the transformer tank 10. The control unit 1 controls S1 the actuator assembly 14 to dynamically excite the transformer arrangement 3 at at least one frequency. By mechanically energizing the transformer tank 10 with electrodynamic shakers and monitoring the resulting vibrational response V using standard vibration sensors it is possible to identify incipient and potentially detrimental changes in the mechanical characteristics of the transformer 12 active part, and in other mechanical sub-structures immersed in the insulating fluid.

Accordingly, the sensor assembly 14 may comprise at least one sensor and may similarly be arranged on the transformer tank 10 and configured to detect S2 a vibrational response V resulting from the excited vibrations. Evolution of the frequency content of the vibrational response V, when compared S3 to the reference response R, will reveal changes to mechanical properties of sub-structures of the transformer arrangement 3.

The threshold value may be set depending on individual transformer arrangements 3 and transformer tank 10 configurations. If structural degradation is determined S4, the control unit 1 may indicate to users or operators of the transformer arrangement what sub-structures have degraded or that the status of the transformer arrangement 3 needs to be investigated further. Alternatively, the control unit 1 may shut down the transformer 12. The control unit 1 may be configured to perform the method 2 continuously or intermittently at pre-determined intervals.

The actuator assembly 14 may be controlled S1 to excite vibrations in the transformer tank 10 over a range of frequencies. As such, the method 2 may be a swept frequency response analysis (SFRA) method, where the actuator assembly 14 excites the transformer arrangement 3 over a wide range of frequencies.

Alternatively, the actuator assembly 14 may be controlled S1 to excite the transformer arrangement 3 around frequencies of interest, such as at frequencies of symmetric and asymmetric resonant vibrational modes of the transformer 12 and of the transformer windings. Particularly energetic axial resonance vibrations of the transformer windings (along an extension of the transformer windings) are known to occur at approximately the double operational frequency of the grid, i.e. at double 50 Hz or 60 Hz, such as at 100 Hz and 120 Hz. Structural changes may be expected to appear at these frequencies due to fatigue of the sub-structures of the transformer 12 and/or transformer arrangement 3. Further, the method 2 and monitoring system 400 of the disclosure allows study of radial resonance vibrations which are also excited during normal operation of the transformer 12.

The range of frequencies may be between 5 Hz and 5000 Hz. The vibrational response V resulting from structural degradation may be hard to predict. A wide frequency range of the excited vibrations may therefore improve the chances of detecting S2 structural changes in the vibrational response V.

When determining S4 a structural degradation of the transformer arrangement 3 at a certain frequency of excitation, the method 2 may further comprise exciting vibrations at frequencies of higher resolution around said frequency. Exciting vibrations at frequencies of higher resolution is understood to mean exciting vibrations in smaller incremental steps around a frequency of interest in order to better characterise deviations of the vibrational response V from the reference response R.

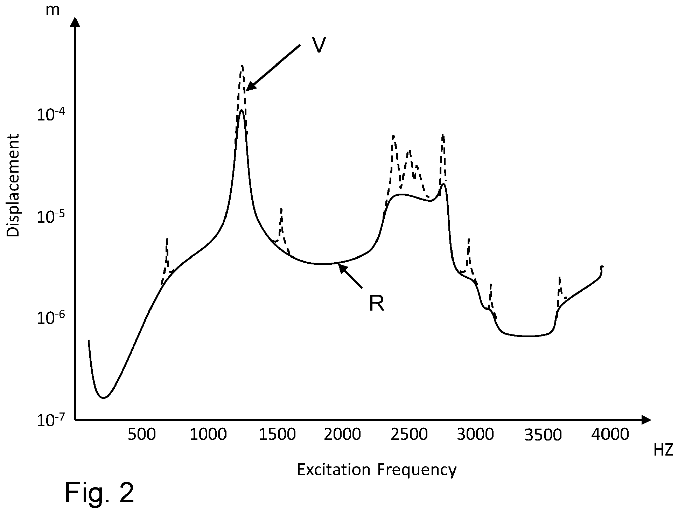

**Fig. 2** depicts an exemplary diagram of a vibrational response V compared to a reference response R of the transformer arrangement 3 according to the third aspect of the disclosure. The vibrational response V and the reference response R are measured in meters (m) of displacement of a structure of the transformer arrangement 3 for a range of excitation frequencies. The reference response R is shown as a solid line and characterises the vibrational response of a newly installed a transformer arrangement 3 of a particular individual configuration of components, arrangements, connections and location. The exemplary vibrational response V is shown as a dashed line which deviates from the reference response R curve at certain frequencies of excitation. The deviations indicate structural changes in the transformer arrangement 3 which are due to degradation of the structural parts transformer arrangement over time.

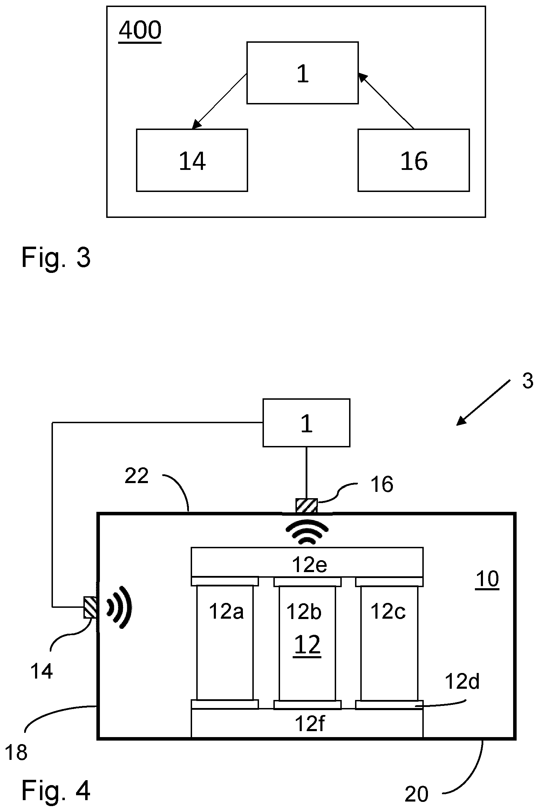

**Fig. 3** shows a schematic example of the monitoring system 400 for monitoring of structural degradation in a transformer arrangement 3 according to the second aspect of the disclosure. The monitoring system 400 comprises at least a control unit 1 and an actuator assembly 14 controllable by the control unit 1 to dynamically excite a transformer tank 10, and a sensor assembly 16 configured to detect a vibrational response V in the transformer tank 10. The control unit 1 is configured to control the actuator assembly 14 to dynamically excite the transformer arrangement 3, to detect, by the sensor assembly 16, a vibrational response V of the transformer arrangement 3, to compare the vibrational response V to a reference response R, and to determine a structural degradation of the transformer arrangement 3 in response to the comparison between the vibrational response V and the reference response R exceeding a threshold value.

As stated hereinabove, the actuator assembly 14 of the monitoring system 400 may comprise at least one actuator, such as an electrodynamic shaker. The sensor assembly 16 may comprise at least one vibration sensor. The control unit 1 may have processing capacity and may be configured to communicate wirelessly, or by cable, with the actuator assembly 14 and with the sensor assembly 16 to perform the actions of the method 2. The monitoring system 400 may further comprise visual and/or audible indicators, such as graphic displays, speakers, etc., to display status and/or to alert operators and users of the transformer arrangement 3 about structural degradation of the transformer arrangement 3. The control unit 1 may further control switches to shut down the transformer 12 in case of detected structural changes which need urgent attention by operators.

**Fig. 4** shows a conceptual view of an example of the transformer arrangement 3 according to the third aspect of the disclosure. The transformer arrangement 3 comprises a transformer tank 10, a transformer 12 enclosed by the transformer tank 10 and immersed in an insulating fluid inside the transformer tank 10, and a monitoring system 400 according to the second aspect of the disclosure. The control unit 1 of the monitoring system 400 is configured to perform the method 2 of the first aspect of the disclosure.

The transformer arrangement 3 may thus comprise a conventional transformer tank 10 and a transformer 12, which are further arranged with a monitoring system 400, as described in conjunction with **Fig. 3** above. The actuator assembly 14 may comprise at least one actuator and the sensor assembly 16 may comprise at least one sensor.

The transformer 12 may be a single-phase transformer or a multi-phase transformer. A three-phase transformer 12, having three phase windings 12a, 12b, 12c is conceptually shown in **Fig. 4****.** The transformer 12 may comprise at least a primary and a secondary winding clamped by press plates 12d (only one out of six press plates indicated by a reference figure in **Fig. 4**) between a top yoke 12e and a bottom yoke 12f of a transformer core. During operation of the transformer 12, the clamping pressure of the press plates may relax, which may lead to unwanted short-circuit events. Other structural changes may also occur. The relaxation of the clamping pressure and other structural changes may be detected by the method 2 and monitoring system 400 described in the present disclosure.

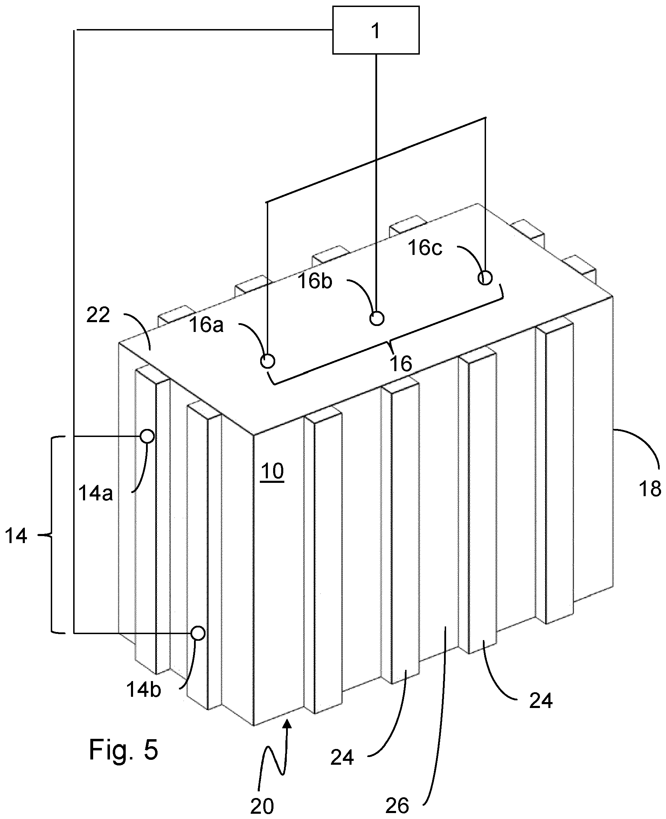

The transformer tank may be formed by, and comprises walls 18, a base 20 and a lid 22. The walls 18 extend between the base 20 and the lid 22 and comprise reinforcing beams 24 (**Fig. 5**) and plate fields 26 (**Fig. 5**) between the beams 24.

The lid 22 of the transformer tank 10 may be made of relatively thick material, e.g., steel of >30 mm. The lid 22 is only conceptually shown in the drawings but may comprise openings for service and inspection and bushings enabling electric connection with the transformer inside the tank. The lid 22 is relatively close to the top press plates 12d of the windings 12a, 12b, 12c of the transformer 12.

The base 20 of the transformer tank 10 is also made of a relatively thick material, e.g steel of >30-40 mm. The transformer 12 is arranged standing on the base 20 inside the transformer tank 10. Therefore, there is a strong mechanical connection between the base 20 and the transformer 12.

The reinforcing beams 24 conventionally strengthen the walls 18 and also suppress vibrations of the walls 18, which vibrations emanate from vibrations of the windings 12a, 12b, 12c during operation of the transformer 12. The vibrations are transferred to the walls 18 via the insulating fluid which surrounds the transformer 12 inside the transformer tank 10. The plate fields 26 are to be understood as parts of the walls 18 which parts are exposed between the beams 24.

Referring to **Fig. 5****,** the actuator assembly 14 is exemplified as comprising two actuators 14a, 14b which may be mounted on at least one beam 24 of the walls 18 of the transformer tank 10. The beams 24 may provide strong energization and mechanical coupling of the transformer tank 10 when exciting the vibrations in the transformer tank 10/transformer arrangement 3 by the actuator assembly 14.

The sensor assembly 16 is exemplified as comprising three sensors 16a, 16b, 16c which may be mounted on the lid 22 of the transformer tank 10. The lid 22 is arranged relatively close to the top end of the windings 12a, 12b, 12c as compared to other parts of the transformer tank 10 which are located further away. Therefore, mounting the sensor assembly 16 on the lid 22 may provide more accurate readings of structural degradation of the transformer due to the proximity to the windings 12a, 12b, 12c and upper press plates 12d.

Alternatively (but not exemplified by drawings), the actuator assembly 14 may be mounted on the lid 22 of the transformer tank 10. The relatively thick material of the lid 22 provides a strong energization and mechanical coupling of the transformer tank 10 when exciting the vibrations by the actuator assembly 14.

Alternatively (but not exemplified by drawings), the actuator assembly 14 may be mounted on the base 20 of the transformer tank 10. The relatively thick material of the base 20 provides a strong energization and mechanical coupling of the transformer tank 10 when exciting the vibrations by the actuator assembly 14. Further, the direct mechanical connection between the base 20 and the transformer 12 results in less reliance on transmission of vibrations through the insulating fluid.

Alternatively (but not exemplified by drawings), the sensor assembly 16 may be mounted on at least one plate field 26 of the transformer tank walls 18 and arranged distanced from adjacent beams 24. Mounting the sensor assembly 16 on a plate field 26 may provide more information about the local vibrational response.

Alternatively (but not exemplified by drawings), the sensor assembly 16 may be mounted on the base 20 of the transformer tank 10. The direct mechanical connection between the base 20 and the transformer 12 results in less reliance on transmission of vibrations through the insulating fluid. Thereby, readings of sensors mounted on the base may be more accurate.

Alternatively (but not exemplified by drawings), the sensor assembly 16 is mounted on an inside of the transformer tank 10. The sensor assembly 16 may be mounted directly on the transformer 12, such as on the windings 12a, 12b, 12c or on the press plates 12d of the transformer. The sensor assembly 16 may be configured to wirelessly communicate with the control unit 1 outside the transformer tank 10, such as by electromagnetic coupling between LC circuits and by a wireless array of LC circuits. The sensor assembly 16 may further be arranged and configured to extend along electric field lines of the transformer 12 in operation in order to reduce interfering electric potentials across the sensor assembly 16.

According to a fourth aspect of the present disclosure, the object is at least partly achieved by a computer program product according to claim 15.

Hence, there is provided a computer program product comprising program code for, when executed by the control unit, performing the method of any one of the embodiments of the first aspect of the disclosure.

According to a fifth aspect of the present disclosure, the object is at least partly achieved by a non-transitory computer-readable storage medium according to claim 16.

Hence, there is provided a non-transitory computer-readable storage medium comprising instructions, which when executed by the control unit of the second aspect of the disclosure, causes the control unit to perform the method of any one of the embodiments of the first aspect of the disclosure.

The control unit may be connected to the non-transitory computer-readable storage medium having thereon the computer program product, which comprises code to cause the control unit to execute the method of the disclosure. The control unit may use the software/computer program product to control excitation of vibrations of the transformer tank. The computer program is configured for the control unit to run the method in the most efficient possible manner. The computer program and the control unit may perform data acquisition and signal processing and run algorithms for assessing whether a change in a recorded vibration spectrum is due to an incipient degradation or not. Assessment of the structural degradation may involve machine learning.

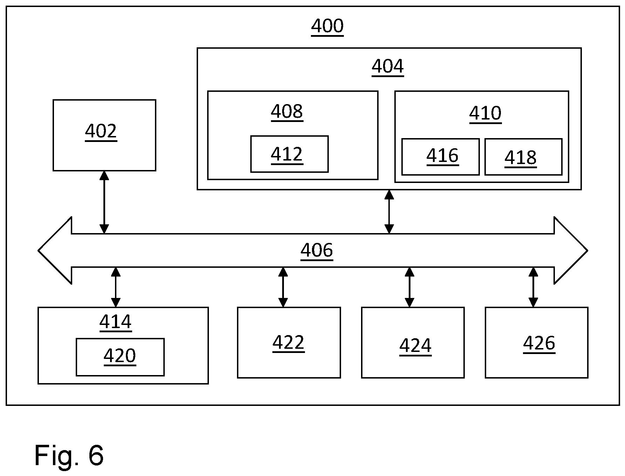

FIG. 6 is a schematic diagram of a monitoring system 400 for implementing examples disclosed herein. The monitoring system 400 is adapted to execute instructions from a computer-readable medium to perform these and/or any of the functions or processing described herein. The monitoring system 400 may be connected (e.g., networked) to other machines in a LAN, an intranet, an extranet, or the Internet. While only a single device is illustrated, the monitoring system 400 may include any collection of devices that individually or jointly execute a set (or multiple sets) of instructions to perform any one or more of the methodologies discussed herein. Accordingly, any reference in the disclosure and/or claims to a monitoring system, computing system, computer device, computing device, control system, control unit 1, electronic control unit (ECU), processor device, etc., includes reference to one or more such devices to individually or jointly execute a set (or multiple sets) of instructions to perform any one or more of the methodologies discussed herein. For example, a monitoring system 400 may include a single control unit 1, or a plurality of control units 1 connected or otherwise communicatively coupled to each other, such that any performed function may be distributed between the control units 1 as desired. Further, such devices may communicate with each other or other devices by various system architectures, such as directly or via a Controller Area Network (CAN) bus, etc.

The monitoring system 400 may comprise at least one computing device or electronic device capable of including firmware, hardware, and/or executing software instructions to implement the functionality described herein. The monitoring system 400 may include a processor device 402 (may also be referred to as a control unit 1), a memory 404, and a system bus 406. The monitoring system 400 may include at least one computing device having the processor device 402. The system bus 406 provides an interface for system components including, but not limited to, the memory 404 and the processor device 402. The processor device 402 may include any number of hardware components for conducting data or signal processing or for executing computer code in memory 404. The processor device 402 (e.g., control unit 1) may, for example, include a general-purpose processor, an application specific processor, a Digital Signal Processor (DSP), an Application Specific Integrated Circuit (ASIC), a Field Programmable Gate Array (FPGA), a circuit containing processing components, a group of distributed processing components, a group of distributed computers configured for processing, or other programmable logic device, discrete gate or transistor logic, discrete hardware components, or any combination thereof designed to perform the functions described herein. The processor device may further include computer executable code that controls operation of the programmable device.

The system bus 406 may be any of several types of bus structures that may further interconnect to a memory bus (with or without a memory controller), a peripheral bus, and/or a local bus using any of a variety of bus architectures. The memory 404 may be one or more devices for storing data and/or computer code for completing or facilitating methods described herein. The memory 404 may include database components, object code components, script components, or other types of information structure for supporting the various activities herein. Any distributed or local memory device may be utilized with the systems and methods of this description. The memory 404 may be communicably connected to the processor device 402/control unit 1 (e.g., via a circuit or any other wired, wireless, or network connection) and may include computer code for executing one or more processes described herein. The memory 404 may include non-volatile memory 408 (e.g., read-only memory (ROM), erasable programmable read-only memory (EPROM), electrically erasable programmable read-only memory (EEPROM), etc.), and volatile memory 410 (e.g., random-access memory (RAM)), or any other medium which can be used to carry or store desired program code in the form of machine-executable instructions or data structures and which can be accessed by a computer or other machine with a processor device 402. A basic input/output system (BIOS) 412 may be in the non-volatile memory 408 and can include the basic routines that help to transfer information between elements within the monitoring system 400.

The monitoring system 400 may further include or be coupled to a non-transitory computer-readable storage medium such as the storage device 414, which may comprise, for example, an internal or external hard disk drive (HDD) (e.g., enhanced integrated drive electronics (EIDE) or serial advanced technology attachment (SATA)), HDD (e.g., EIDE or SATA) for storage, flash memory, or the like. The storage device 414 and other drives associated with computer-readable media and computer-usable media may provide non-volatile storage of data, data structures, computer-executable instructions, and the like.

A number of modules can be implemented as software and/or hard-coded in circuitry to implement the functionality described herein in whole or in part. The modules may be in the storage device 414 and/or in the volatile memory 410, which may include an operating system 416 and/or one or more program modules 418. All or a portion of the examples disclosed herein may be implemented as a computer program product 420 on a transitory or non-transitory computer-usable or computer-readable storage medium (e.g., single medium or multiple media), such as the storage device 414, which includes complex programming instructions (e.g., complex computer-readable program code) to cause the processor device 402 to carry out the steps described herein. Thus, the computer-readable program code can comprise software instructions for implementing the functionality of the examples described herein when executed by the processor device 402 (control unit 1). The processor device 402 may serve as a controller or control unit 1 for the monitoring system 400 that is to implement the functionality described herein.

The monitoring system 400 may also include an input device interface 422 (e.g., input device interface and/or output device interface). The input device interface 422 may be configured to receive input and selections to be communicated to the monitoring system 400 when executing instructions, such as from a keyboard, mouse, touch-sensitive surface, etc. Such input devices may be connected to the processor device 402/control unit 1 through the input device interface 422 coupled to the system bus 406 but can be connected through other interfaces such as a parallel port, an Institute of Electrical and Electronic Engineers (IEEE) 1394 serial port, a Universal Serial Bus (USB) port, an IR interface, and the like. The monitoring system 400 may include an output device interface 424 configured to forward output, such as to a display, a video display unit (e.g., a liquid crystal display (LCD) or a cathode ray tube (CRT)). The monitoring system 400 may also include a communications interface 426 suitable for communicating with a network as appropriate or desired.

The operational steps described in any of the exemplary aspects herein are described to provide examples and discussion. The steps may be performed by hardware components, may be embodied in machine-executable instructions to cause a processor to perform the steps, or may be performed by a combination of hardware and software. Although a specific order of method steps may be shown or described, the order of the steps may differ. In addition, two or more steps may be performed concurrently or with partial concurrence.

The terminology used herein is for the purpose of describing particular aspects only and is not intended to be limiting of the disclosure. As used herein, the singular forms "a," "an," and "the" are intended to include the plural forms as well, unless the context clearly indicates otherwise. As used herein, the term "and/or" includes any and all combinations of one or more of the associated listed items. It will be further understood that the terms "comprises," "comprising," "includes," and/or "including" when used herein specify the presence of stated features, integers, steps, operations, elements, and/or components, but do not preclude the presence or addition of one or more other features, integers, steps, operations, elements, components, and/or groups thereof.

It will be understood that, although the terms first, second, etc., may be used herein to describe various elements, these elements should not be limited by these terms. These terms are only used to distinguish one element from another. For example, a first element could be termed a second element, and, similarly, a second element could be termed a first element without departing from the scope of the present disclosure.

Relative terms such as "below" or "above" or "upper" or "lower" or "horizontal" or "vertical" may be used herein to describe a relationship of one element to another element as illustrated in the Figures. It will be understood that these terms and those discussed above are intended to encompass different orientations of the device in addition to the orientation depicted in the Figures. It will be understood that when an element is referred to as being "connected" or "coupled" to another element, it can be directly connected or coupled to the other element, or intervening elements may be present. In contrast, when an element is referred to as being "directly connected" or "directly coupled" to another element, there are no intervening elements present.

Unless otherwise defined, all terms (including technical and scientific terms) used herein have the same meaning as commonly understood by one of ordinary skill in the art to which this disclosure belongs. It will be further understood that terms used herein should be interpreted as having a meaning consistent with their meaning in the context of this specification and the relevant art and will not be interpreted in an idealized or overly formal sense unless expressly so defined herein.

It is to be understood that the present disclosure is not limited to the aspects described above and illustrated in the drawings; rather, the skilled person will recognize that many changes and modifications may be made within the scope of the present disclosure and appended claims. In the drawings and specification, there have been disclosed aspects for purposes of illustration only and not for purposes of limitation, the scope of the inventive concepts being set forth in the following claims.

## Claims

1. A computer-implemented method (2) for monitoring of structural degradation in a transformer arrangement (3) comprising a transformer tank (10), and a transformer (12) enclosed by the transformer tank (10) and immersed in an electrically insulating fluid inside the transformer tank (10), the method being performed by a monitoring system (400) comprising a control unit (1), an actuator assembly (14) controllable to dynamically excite the transformer arrangement (3), and a sensor assembly (16) configured to detect a vibrational response (V) in the transformer tank (10) of the transformer arrangement (3), the method (2) comprising, by the control unit (1):
- controlling (S1) the actuator assembly (14) to dynamically excite the transformer arrangement (3),
- detecting (S2), via the sensor assembly (16), a vibrational response (V) of the transformer arrangement (3),
- comparing (S3) the vibrational response (V) to a reference response (R), and
- determining (S4) a structural degradation of the transformer arrangement (3) in response to the comparison between the vibrational response (V) and the reference response (R) exceeding a threshold value.

2. The method (2) of claim 2, wherein the actuator assembly (14) is controlled to dynamically excite the transformer arrangement (3) over a range of frequencies.

3. The method (2) of claim 2, wherein the range of frequencies is between 5 Hz and 5000 Hz.

4. The method (2) of any of claims 2-3, wherein, upon determining (S4) the structural degradation of the transformer arrangement (3) at a certain frequency of excitation, further exciting (S5) vibrations at frequencies of higher resolution around said frequency.

5. A monitoring system (400) for monitoring of structural degradation in a transformer arrangement (3), the monitoring system (400) comprising a control unit (1) and an actuator assembly (14) controllable by the control unit (1) to dynamically excite the transformer tank (10), and a sensor assembly (16) configured to detect a vibrational response (V) in the transformer tank (10), the control unit (1) being configured to:
- control the actuator assembly (14) to dynamically excite the transformer arrangement (3),
- detect by the sensor assembly (16) a vibrational response (V) of the transformer arrangement (3),
- compare the vibrational response (V) to a reference response (R), and
- determine a structural degradation of the transformer arrangement (3) in response to the comparison between the vibrational response (V) and the reference response (R) exceeding a threshold value (T).

6. A transformer arrangement (3) comprising a transformer tank (10), a transformer (12) enclosed by the transformer tank (10) and immersed in an electrically insulating fluid inside the transformer tank (10), the transformer arrangement further comprising a monitoring system (400) according to claim 5.

7. The transformer arrangement (3) of claim 6, wherein the transformer tank (10) is formed by, and comprises walls (18), a base (20) and a lid (22), which walls (18) extend between the base (20) and the lid (22) and which walls (18) comprise reinforcing beams (24) and plate fields (26) between the beams (24).

8. The transformer arrangement (3) of claim 7, wherein the actuator assembly (14) is mounted on at least one beam (24) of the walls (18) of the transformer tank (10).

9. The transformer arrangement (3) of any of claims 7-8 wherein the actuator assembly (14) is mounted on the lid (22) of the transformer tank (10).

10. The transformer arrangement (3) of any of claims 7-9 wherein the actuator assembly (14) is mounted on the base (20) of the transformer tank (10).

11. The transformer arrangement (3) of any of claims claim 8-10, wherein the sensor assembly (16) is mounted on at least one plate field (26) of the transformer tank walls (18) and arranged distanced from adjacent beams (24).

12. The transformer arrangement (3) of any of claims 8-11 wherein the sensor assembly (16) is mounted on the lid (22) of the transformer tank (10).

13. The transformer arrangement (3) of any of claims 8-12 wherein the sensor assembly (16) is mounted on the base (20) of the transformer tank (10).

14. The transformer arrangement (3) of claim 7, wherein the sensor assembly (16) is mounted on an inside of the transformer tank (10).

15. A computer program product (420) comprising program code for performing, when executed by the control unit (1), the method of any of claims 1-4.

16. A non-transitory computer-readable storage medium (414) comprising instructions, which when executed by the control unit (1), cause the control unit (1) of claim 5 to perform the method (2) of any of claims 1-4.
